# EUROPEAN PATENT SPECIFICATION

(11) **EP 0 517 033 B1**
(45) Date of publication and mention of the grant of the patent: **03.01.1996**
(21) Application number: 92108511.4
(22) Date of filing: 20.05.1992
(51) Int. Cl.: H01L 21/00

(54) **Cleaning device for wafer mount plate**
Reinigungsvorrichtung für Plättchen-Halterungsplatte
Dispositif de nettoyage pour plateau de montage de plaquettes

(30) Priority: 06.06.1991 JP 160904/91
(43) Date of publication of application: 09.12.1992
(73) Proprietor: ENYA SYSTEMS LIMITED, Kawagoe-shi, Saitama-ken (JP)
(72) Inventor: Suzuki, Shizuo, Oume-shi, Toyko (JP); Yokosuka, Noriyoshi, Iruma-shi, Saitama-ken (JP)
(74) Representative: Klingseisen, Franz, Dipl.-Ing.

(56) References cited:
- EP-A- 0 402 520
- PATENT ABSTRACTS OF JAPAN vol. 12, no. 135 (E-604)23 April 1988 &JP-A-62 259 447
- PATENT ABSTRACTS OF JAPAN vol. 8, no. 209 (E-268)22 September 1984 & JP-A-59 094 425

## Description

The invention relates to a cleaning device according to the preamble of claim 1.

Such a cleaning device is known from EP-A-0 402 520 which shows the cleaning of a wafer mount plate by means of a washing brush in combination with a washing liquid and subsequent drying by blowing a gas.

JP-A-59 094 425 discloses a cleaning device for cleaning a wafer to remove dust adhering on a light-weight and thin substrate. Rollers are provided for supporting a wafer and brushes for cleaning both the surface and the back of the wafer.

JP-A-62 259 447 discloses the use of brushes for cleaning the upper surface, the side and parts of the lower surface of a wafer.

In semiconductor manufacturing steps, it is required to make the surface of the wafers extremely smooth. In general, wafers are pasted on the mount plate by use of an adhesive such as a wax diluted by a solvent, and the mount plate is set on a polishing machine to polish the wafers. However, if the adhesive between the wafers and the mount plate is not applied thinly and uniformly, minute unevenness is formed on the surface when polishing is conducted and it becomes difficult to obtain high flatness.

Further, if fine dust exists on the surface of the mount plate, the above adhesive tends to form dimples at the parts of the dust, etc. and to become a cause of preventing uniform pasting of the wafers. Therefore, after completion of the polishing operation, the wafers are peeled from the mount plate, and such a mount plate should be thoroughly washed so that the adhesive or the like would not remain as the dust.

Since the above mount plate is repeatedly used for the polishing step, the mount plate is made of a material such as ceramics or a glass, which undergoes small deformation against aged deterioration and load. Various kinds of disks each having a diameter of several tens of centimeters and a thickness of about 20 millimeters, are prepared so that various kinds of wafers each having different sizes may be pasted thereon each in a plural number. The weight thereof is mainly from about 20 kg to 30 kg or more.

At present, as the device for cleaning the mount plate, there is known, e.g. a device in which the mount plate is washed during it is transported, before pasting the wafers thereon. Such a device comprises upper and lower laterally elongated cylindrical brush rolls across a conveying path of the mount plate, so that the upper and lower surfaces of the mount plate can be washed by brushing when the mount plate passes between the brush rolls. However, since the diameter of the mount plate is large as mentioned above, it is required that the brush rolls are laterally elongated to have the length longer than the diameter of the mount plate. Thus, if a part of the brush roll is curved even a little, it sometimes causes that a part of the surface of the mount plate remains unwashed.

Besides, since the peripheral side surface (edge surface) of the mount plate can not be washed, the adhesive remaining on this portion tends to peel off in powdery form at the step of mounting the wafers upon, and adhere on a mounting surface, and becomes a cause of the formation of dimples in an adhesive coating step.

In addition, it is necessary for removing the adhesive by washing to provide continuous steps of removing first the adhesive, then brushing the surface with pure water, and finally rinsing it. Thus, the device tends to become extremely large in size, and cause a drawback that the device can not be obtained economically.

A device is known in which the mount plate is washed by immersing it in an organic solvent bath. This device comprises a heated organic solvent bath, a normal temperature organic solvent bath, an organic solvent vapor bath, etc., wherein the above mount plate is sequentially immersed in each bath to wash it, followed by drying. However, since the surface of the mount plate is not brushed, the effect for washing is insufficient. In addition, since the mount plate is heavy and large as compared with the wafers, each bath for immersing it, is large and requires a large area for installation. In recent years, a cleaning method wherein no organic solvent is employed, has been highly appreciated from the viewpoints of air pollution, and safety and hygienic problems. It is necessary to improve the conventional devices from such viewpoints also.

An object of the present invention is to provide a cleaning device for the wafer mount plate in which,before the wafers are pasted on the mount plate for polishing, the steps of removing the adhesive, etc. adhered to the mount plate, washing it with pure water and drying it, are conducted at one position without occupying a large space, and such a device can readily be adapted to automation.

Another object of the present invention is to provide a cleaning device for the wafer mount plate which can wash the whole surface of the wafer mount plate clean.

According to the present invention, the above objects are accomplished by the features in the characterizing part of claim 1.

Other objects and features of the present invention will become apparent to those skilled in the art upon reading the following description with reference to the accompanying drawings.

### BRIEF DESCRIPTION OF THE DRAWINGS

Fig. 1 is a schematic structural view of a cleaning device for a wafer mount plate of the present invention.

Fig. 2 is a plane view of the device of the present invention wherein the cover of the device is detached.

Fig. 3 is a side view of the device of the present invention.

Fig. 4 is a front view, partially in cross section, of a receiving roller section of the device of the present invention.

Fig. 5 is a side view of a part of the receiving roller section of Fig. 4.

Fig. 6 is a front view of a driving roller section of the device of the present invention.

Fig. 7 is a sectional side view of a rail part of the driving roller section of Fig. 6.

Fig. 8 is a front view of an upper surface washing brush section of the device of the present invention.

Fig. 9 is a front view of a lower surface washing brush section of the device of the present invention.

Fig. 10 is a front view of a side surface washing brush section of the device of the present invention.

Fig. 11 is a front view of an upper nozzle section of the device of the present invention.

Fig. 12 is a side view of the upper nozzle section of Fig. 11.

Fig. 13 is a front view of a lower nozzle section of the device of the present invention.

### DESCRIPTION OF THE PREFERRED EMBODIMENTS

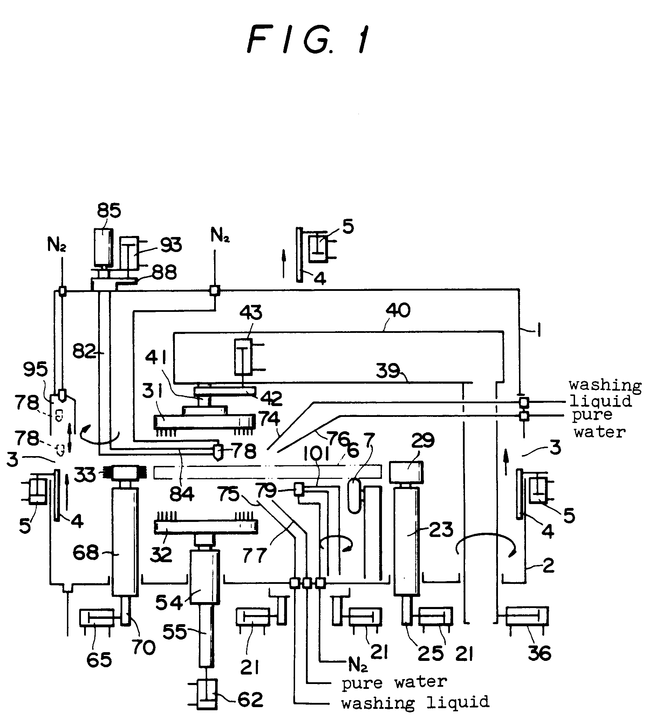

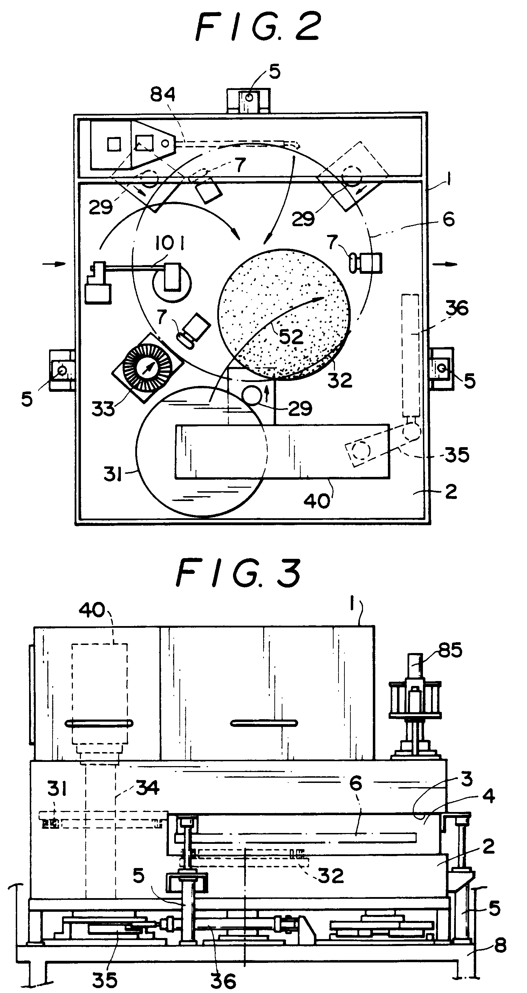

Fig. 1 shows a schematic structural view of the present invention, Fig. 2, a plane view, and Fig. 3, a side view. In these drawings, a body 1 comprises at the lower portion a sink 2 which collects and discharges cleaning liquid, etc., and at the upper portion a cover for hermetically covering the body. The body has a shutter 4 of substantially C-like plane at opening 3 formed around the both side surfaces and the back. The openings 3 is opened or closed by moving up and down the shutter 4 by means of each of air cylinders 5, 5 and 5.

When the opening 3 is open, a mount plate 6 is carried into the body 1 by means of an appropriate robot means, and rotatably supported on receiving rollers 7 so that it would rotate round its own axis in a horizontal condition. The receiving rollers 7 are disposed at at least three portions in the circumferential direction of the mount plate, but these may be disposed at more than three portions.

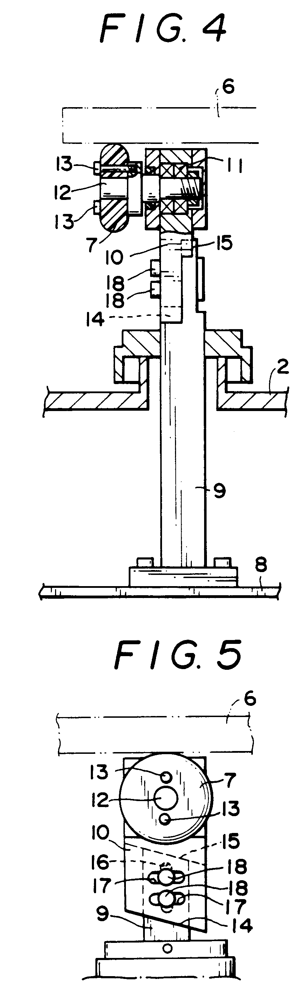

As shown in Figs. 4 and 5, a frame 8 has a supporting rod 9 standing up thereon, and the supporting rod 9 has a housing 10 disposed at the upper portion. The housing 10 has a shaft 12 rotatably disposed by way of a bearing 11, and the receiving roller 7 is disposed at the top of the shaft 12. The receiving roller 7 is made of a synthetic resin material having a high chemical resistance, such as polyvinylidene fluoride (PVDF), and, if the roller is abraded, it may be changed with new one readily by unfastening a bolt 13.

Further, as shown in Fig. 5, the lower end of the housing 10 and the upper end of the supporting rod 9 are engaged by way of inclined surfaces 14 and 15. The supporting rod 9 has a longitudinally elongated fitting slit 16, and the housing 10 has a laterally elongated fitting slit 17. A bolt 18 is inserted through the fittingslits to tighten these members. Thus, by moving the housing 10 right and left along the inclined surface, the height of the receiving roller 7 can be adjusted up or low.

The mount plate 6 can be rotated round its own axis by driving the receiving roller, but, in the drawing, three driving rollers are brought into contact with the peripheral side surface of the mount plate at three portions to rotate the mount plate itself.

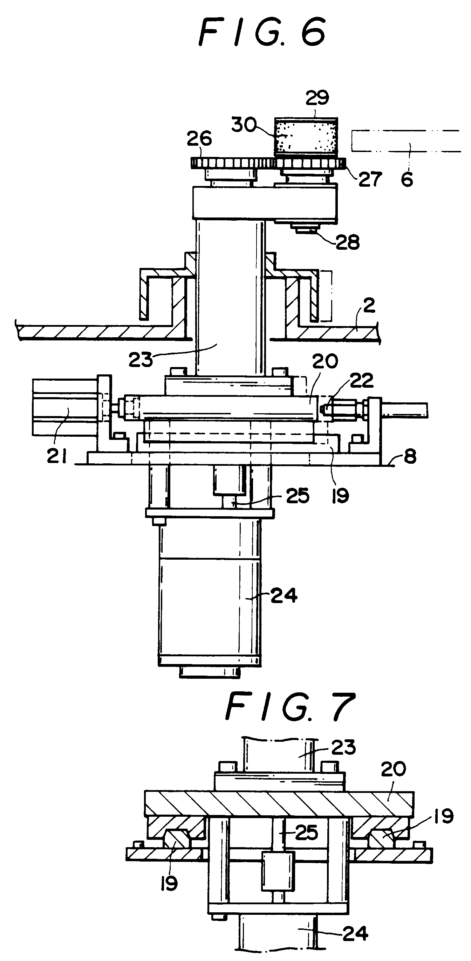

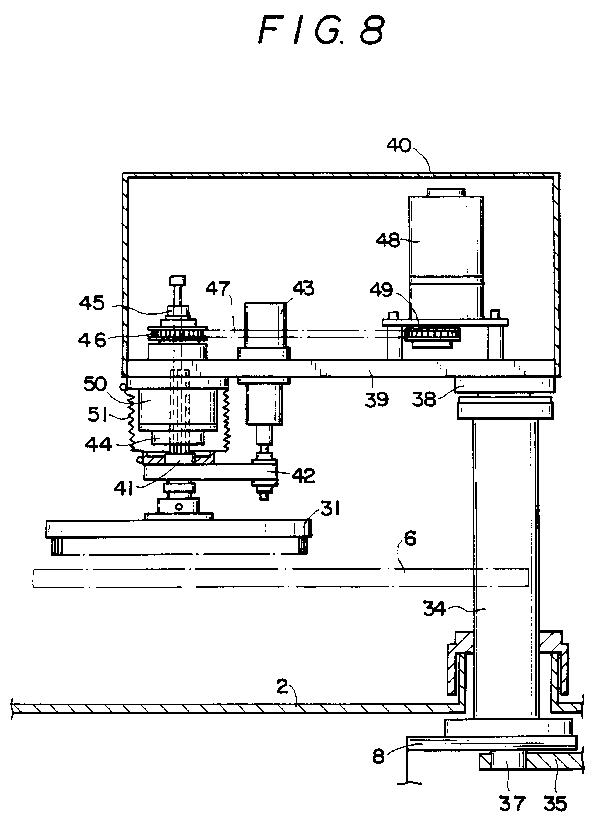

Fig. 6 shows an embodiment of a driving roller. On a rail 19, 19 (as shown in Fig. 7) disposed on the frame, a slide base 20 is provided so that the slide base 20 may be slidably moved toward the center of the mount plate by means of an air cylinder 21. A buffering member 22 is disposed against one end of the slide base 20. A driving shaft 25 connected to a motor 24, is inserted through the housing 23 standing up toward the upper portion. The driving shaft serves to rotate a roller shaft 28 by means of gears 26 and 27 disposed at the upper portion of the driving shaft, thereby rotating a driving roller 29 disposed on the roller shaft 28.

On the periphery of the driving roller 29, a lining layer 30 made of an elastic material such as a synthetic rubber or a soft synthetic resin material, is disposed. It is preferred to prepare plural driving rollers each having different diameter so that plural mount plates each having different diameter can be used. As shown in Fig. 2, the driving rollers are disposed at three portions on the periphery of the mount plate, but may be disposed at more portions, or a part of the rollers may be used as a non-drivingroller.

Against the upper surface, lower surface and peripheral surface of the mount plate mounted on the receiving roller, an upper surface washing brush 31, a lower surface washing brush 32 and a side surface washing brush 33 are disposed so that each of them is slidably in contact with each of the surfaces.

Fig. 8 shows one embodiment of the upper surface washing brush 31. In this drawing, a main shaft 37 is inserted through a stand 34 standing on the frame 8. The main shaft is rotated by an air cylinder 36 (reference may be made with Figs. 1 to 3) by way of a link 35. At the top of the main shaft 37, an arm 39 is fixed by way of a flange 38. The periphery of the arm is covered by a cover 40.

At the top section of the arm 39, a cylinder 43 is adapted to move up and down a lift plate 42 which rotatably supports a shaft 41 of the upper surface washing brush 31 having a disk-like plate of which the lower surface is bristled. A part of the shaft 41 of the brush is formed as a spline shaft with which a ball spline 44 is engaged. A timing pulley 46 is fixed to a shaft holder 45 having the ball spline 44 at the end. The . timing pulley 46 is connected to a timing pulley 49 attached to a motor 48, by way of a timing belt 47. A housing 50 which rotatably supports the shaft holder 45, is fixed to the lower surface of the arm 39 and is surrounded with a bellows 51.

By such a construction, the upper surface washing brush 31 can be rotated by the motor 48 and moved up and down by the cylinder 43. In addition, the upper surface washing brush 31 can be turned toward the arrow direction 52 in Fig. 2, by operating the air cylinder 36.

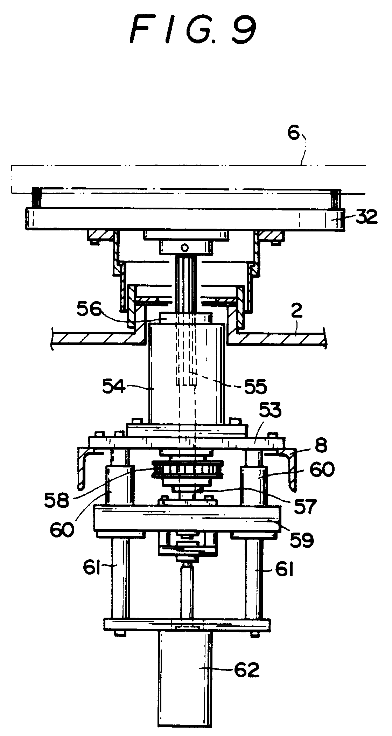

Fig. 9 shows one embodiment of the part of the lower surface washing brush 32, wherein a housing 54 stands on a base 53 disposed on the frame 8, and a spline shaft 55 is inserted through the housing. Between the spline shaft 55 and the housing 54, a shaft holder 57 is rotatably disposed, which has at the upper end a ball spline 56 engaging with the spline shaft 55. To a timing pulley 58 disposed at the lower end of the shaft holder 57, a motor (not shown in the drawing) is connected by way of a timing belt and a pulley which are omitted in the drawing.

The lower end of the spline shaft 55 is rotatably connected to a bearing holder 59. The bearing holder 59 is guided with a slide bush 60 and a guide shaft 61, and is moved up and down by the operation of an air cylinder 62. At the upper end of the spline shaft 55, the lower surface washing brush 32 having a disk-like plate of which the upper surface is bristled,is fixed.

By the above structure, the lower surface washing brush 32 is rotated by a motor (not shown in the drawing), and is moved up and down by the cylinder 62. The lower surface washing brush may be turned similarly as the upper surface washing brush 31.

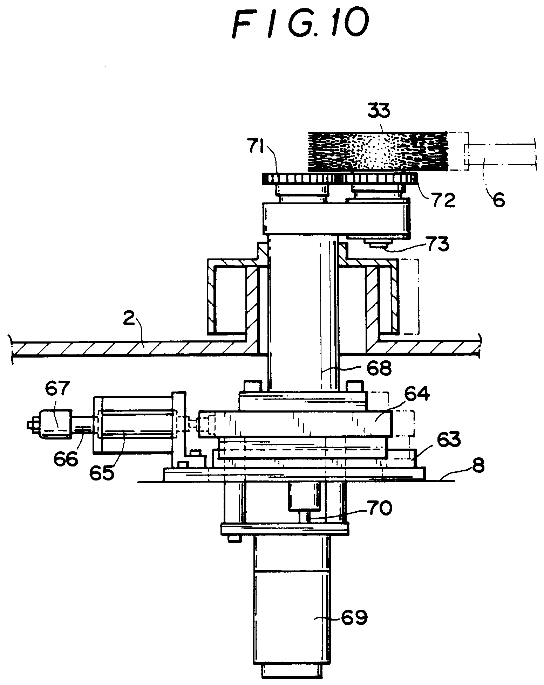

Fig. 10 is one embodiment of the part of the side surface washing brush 33, which has a basically similar structure to the mechanism of the driving rollers as shown in Figs. 6 and 7 as mentioned above. Namely, on a rail 63 provided on the frame, a slide base 64 is mounted in such a way that the slide base 64 may be slidably moved toward the center of the mount plate by means of an air cylinder 65. The range of movement of the slide base 64 is restricted by a stopper 67 attached to a rod 66 of the air cylinder 65. Into a housing 68 standing on the slide base 64, a driving shaft 70 connected to a motor 69, is inserted. A brush shaft 73 is rotated by way of gears 71 and 72 provided on the upper portion of the driving shaft, whereby the side surface washing brush 33 attached to the brush shaft 73 is rotated.

The side surface washing brush 33 has a disk-like plate being thicker than the mount plate 6, and the periphery of the plate is bristled radially. Plural side surface washing brushes each having different diameter are prepared so that plural mount plates each having different diameter may be used.

On each of the upper and lower surfaces of the mount plate, nozzles 74 and 75 for supplying washing liquid and nozzles 76 and 77 for supplying pure water are disposed as shown in Fig. 1. In order to dry the mount plate, nozzles 78 and 79 for supplying a gas such as air or nitrogen gas are disposed. The gas such as air or nitrogen gas, may appropriately be heated. The respective nozzles may be of a fixed type or appropriately a turning type. In the embodiment as shown in the drawing, the nozzle for blowing nitrogen gas is of the turning type, and the other nozzles are of the fixed type. In addition, as the applicant has previously proposed, if the adhesive to be used for the wafers is an adhesive soluble in an aqueous alkali solution, such as a resin comprising as a main component a tricylic compound typified by abietic acid such as rosin, a derivative of the resin, or a modified product of the resin with a dibasic acid, or a mixture of two or more of them, it is useful to use the washing liquid of an aqueous solution, such as an organic alkali, inorganic alkali or inorganic alkali salt, or a mixture of two or more of them.

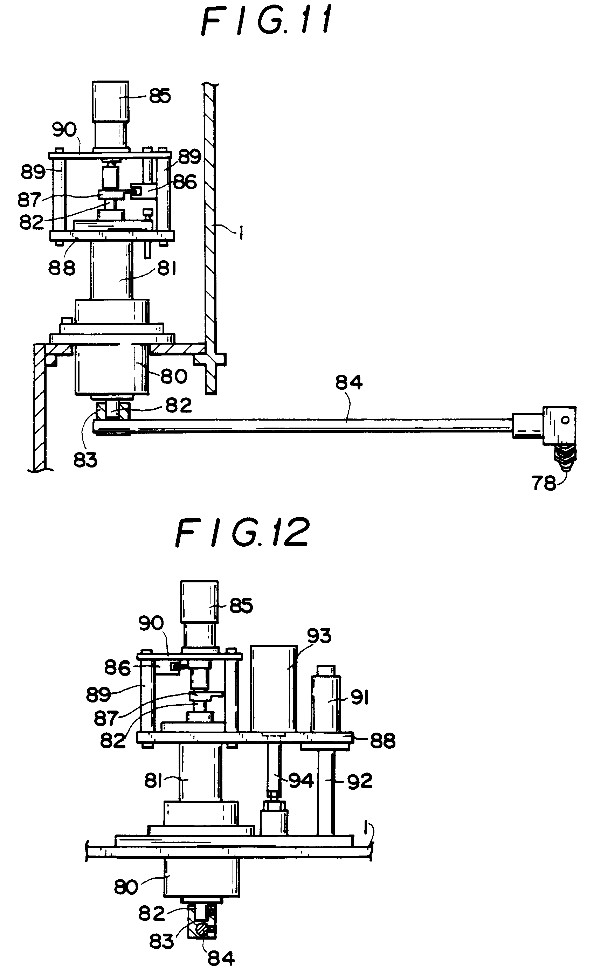

Figs. 11 and 12 show one embodiment of the upper nozzle. In these drawings, in a slide bush 80 fixed to the body 1, a bearing holder 81 is inserted in such a way that it can move up and down. In the bearing holder 81, a shaft 82 is pivotally supported. At the top of the shaft 82, a nozzle shaft 84 is fixed by way of a nozzle holder 83. At the top of the nozzle shaft 84, the nozzle 78 is disposed.

The upper end of the shaft 82 is connected to a motor 85. At a part of the shaft 82, a sensor cut 87 for operating a sensor 86 is disposed, and the shaft 82 is turned by the motor 85. The range of movement of the shaft is restricted by the operation of the sensor.

At the upper end of the bearing holder 81, an elevating plate 88 is fixed. On the elevating plate 88, a motor plate 90 which supports the motor 85 by way of a supporting column 89, is fastened. At one end of the elevating plate 88, a slide bush 91 is disposed as shown in Fig. 12, and a guide shaft 92 is inserted through the slide bush 91. A rod 94 of a cylinder 93 disposed on the elevating plate 88 is fixed at its end, to the body 1. By the operation of the cylinder 93, the nozzle 78 is moved up and down by way of the elevating plate 88, bearing holder 81 and shaft 82.

The upper nozzle 78 is turned under the condition that the shaft 82 is moved down, and at the turned-back position, the upper nozzle is contained in a cover section 95 disposed in the body under the condition that the upper nozzle is moved up as shown by a chain line in Fig. 1. Further, by blowing a gas such as nitrogen gas into the cover section 95, the upper nozzle is dried.

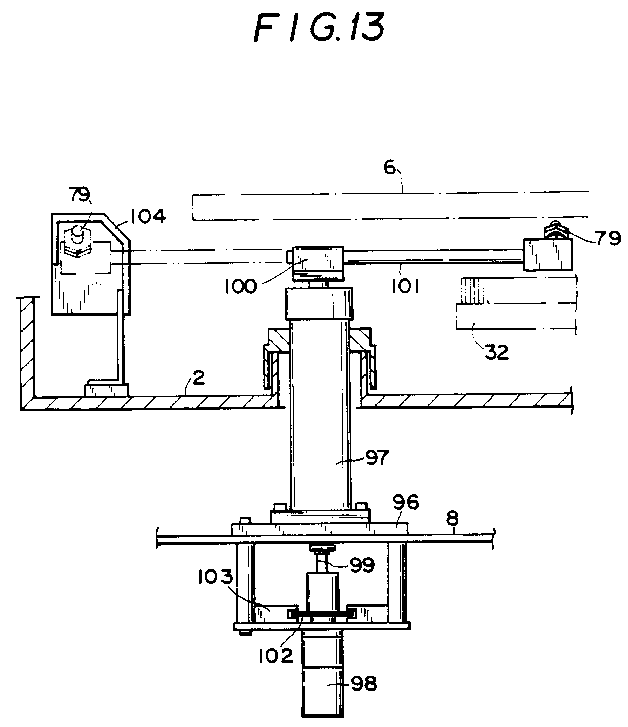

Fig. 13 shows one embodiment of the lower nozzle. On a base 96 fastened to the frame, a housing 97 stands up. A shaft 99 connected to a motor 98, is inserted through the housing 97. At the end of the shaft 99, a nozzle shaft 101 is disposed by way of a nozzle holder 100. At the end of the nozzle shaft 101, the nozzle 79 is disposed. The nozzle shaft 101 is turned by means of the motor 98, the range of turning is controlled by a sensor cut 102 and a sensor 103. The nozzle 79 is contained in a cover 104 disposed in the body at the turned-back position.

As shown in Figs. 4 to 6, 8 to 10 and 13, at a through-hole section of the sink 2, a rising wall and a cover are formed to prevent the leakage of the washing liquid or the like.

Thus, when the shutter 4 of the opening 3 is opened, and the mount plate 6 is mounted on the receiving roller 7 by means of the robot means, driving rollers 29 are brought into contact with the periphery of the mount plate 6 by the cylinder 21 to cramp and rotate the mount plate round its own axis. The number of revolutions thereof is preferably from about several tens to about 100 rpm. After the mount plate is carried therein, the shutter 4 is closed.

While supplying the washing liquid from the nozzle 74, the upper surface washing brush 31 is turned under rotating, and moved down on the upper surface of the mount plate 6. Then, while spraying the washing liquid onto the lower surface of the mount plate from the nozzle 75, the lower surface washing brush 32 and the side surface washing brush 33 are rotated and brought into contact with the mount plate by means of the cylinders 62 and 65. In this time, the upper surface washing brush 31 and the lower surface washing brush 32 each are rotated to reverse directions.

When the foreign matter adhered to the surface of the mount plate, for example, an adhesive such as a wax, is removed, the supply of the washing liquid is terminated, and pure water is supplied from the nozzles 76 and 77 to wash the surface with the pure water. As the case requires, rinsing may be conducted.

Then, the lower surface washing brush and the side surface washing brush are moved back by means of the cylinders 62 and 65, and further the upper surface washing brush is moved back by means of the cylinders 36 and 43, and then, the upper nozzle 78 and the lower nozzle 79 are turned and nitrogen gas is blowed. to the mount plate to dry the whole surface of the mount plate.

After completion of the above-mentioned steps, the shutter 4 of the opening 3 is again opened, and the mount plate is taken away from the body by the robot means, and then the next mount plate is carried therein. These steps are repeated to automatically wash the mount plate sequentially.

The device of the present invention is constituted as mentioned above, wherein the mount plate is rotated round its own axis on the receiving roller and simultaneously washed by brushing the whole surface of the upper surface and lower surface as well as the side surface, without occupying a large area as in the conventional manner. Further, by using the above-mentioned washing liquid of an aqueous alkali solution, the washing can be conducted safely and hygienically without using the organic solvent, and the cost is about one-tenth of the case where the organic solvent is used. Also, the size of the device is about one-third as compared with the conventional device having brushes lined up therein, and thus the device can be installed in a small space. In addition, by changing the driving rollers and side surface washing brush, it is possible to wash mount plates each having different diameter

## Claims

1. Cleaning device for a wafer mount plate (6) formed into a disk-like shape having a surface for mounting wafers thereon by an adhesive, comprising means for washing and subsequently drying the wafer mount plate (6) by blowing a gas thereon, characterized in that it comprises
receiving rollers (7) for supporting the wafer mount plate (6) so as to rotate the wafer mount plate (6) round its own axis horizontally,
an upper surface washing brush (31) for being slidably in contact with an upper surface of the wafer mount plate (6), a lower surface washing brush (32) for being slidably in contact with a lower surface of the wafer mount plate (6), a side surface washing brush (33) for being slidably in contact with a peripheral side surface of the wafer mount plate (6),
at least one driving roller (29) for being in contact with the peripheral side surface of the mount plate for rotating the mount plate (6) round its own axis on the receiving roller (7), and
nozzles (78, 79) for blowing a gas to the upper and lower surfaces of the wafer mount plate (6), each nozzle (78, 79) being pivotal between an active position for blowing against the respective surface and a stand-by position for being contained in a cover (95, 104).

2. Cleaning device according to claim 1,
wherein three driving rollers (29) are provided to surround the wafer mount plate.

3. Cleaning device according to claim 1,
wherein each of the upper surface washing brush (31), the lower surface washing brush (32) and the side surface washing brush (33) can be brought into and out of contact with the wafer mount plate (6).

## Patentansprüche

1. Reinigungsvorrichtung für eine Plättchen-Halterungsplatte (6), die zu einer scheibenförmigen Gestalt mit einer Fläche zum Halterung von Plättchen an dieser mittels eines Klebemittels ausgebildet ist, mit einem Mittel zum Waschen und anschließendem Trocknen der Plättchen-Halterungsplatte (6) durch Aufblasen eines Gases, **dadurch gekennzeichnet,** daß sie aufweist
Aufnahmerollen (7) zum Abstützen der Plättchen-Halterungsplatte (6) derart, daß sich die Plättchen-Halterungsplatte (6) horizontal um ihre eigene Achse dreht,
eine Oberseiten-Waschbürste (31), die in Berührung mit der Oberseite der Plättchen-Halterungsplatte (6) verschiebbar ist,
eine Unterseiten-Waschbürste (32), die in Berührung mit der Unterseite der Plättchen-Halterungsplatte (6) verschiebbar ist,
eine Seitenflächen-Waschbürste (33), die in Berührung mit der Umfangsseitenfläche der Plättchen-Halterungsplatte (6) verschiebbar ist,
mindestens eine Antriebsrolle (29), die in Berührung mit der Umfangsseitenfläche der Halterungsplatte zum Drehen der Halterungsplatte (6) um deren eigene Achse an der Aufnahmerolle (7) steht, und
Düsen (78, 79) zum Aufblasen eines Gases auf die Oberseite und die Unterseite der Plättchen-Halterungsplatte (6), wobei jede Düse (78, 79) zwischen einer aktiven Stellung zum Aufblasen des Gases gegen die jeweilige Fläche und einer Bereitschaftsstellung zur Aufnahme in einer Abdeckung (95, 104).

2. Reinigungsvorrichtung nach Anspruch 1, wobei drei Antriebsplatten (29) derart vorgesehen sind, daß sie die Plättchen-Halterungsplatte umgeben.

3. Reinigungsvorrichtung nach Anspruch 1, wobei sowohl die Oberseiten-Waschbürste (31) als auch die Unterseiten-Waschbürste (32) als auch die Seitenflächen-Waschbürste (33) mit der Plättchen-Halterungsplatte (6) in Berührung und außer Berührung gebracht werden können.

## Revendications

1. Dispositif de nettoyage pour plateau de montage de plaquette (6) réalisé en forme de disque avec une surface destinée au montage de plaquettes ou pastilles au moyen d'une substance adhésive, comprenant des moyens pour laver puis sécher le plateau de montage de plaquettes (6) en y insufflant un gaz, caractérisé en ce qu'il comprend
des rouleaux de réception (7) pour supporter le plateau de montage de plaquettes (6) de façon à faire tourner le plateau de montage de plaquettes (6) autour de son axe horizontalement,
une brosse de lavage de surface supérieure (31) pouvant être mise en contact coulissant avec une surface supérieure du plateau de montage de plaquettes (6), une brosse de lavage de surface inférieure (32) étant en contact coulissant avec une surface inférieure du plateau de montage de plaquettes (6), une brosse de lavage de surface latérale (33) étant en contact coulissant avec une surface latérale périphérique du plateau de montage de plaquettes (6)
au moins un rouleau d'entraînement (29) étant en contact avec la surface latérale périphérique du plateau de montage pour mettre en rotation le plateau de montage (6) autour de son propre axe sur le rouleau de réception (7) et
des tuyères (78, 79) pour insuffler un gaz sur les surfaces supérieure et inférieure du plateau de montage de plaquettes (6), chaque tuyère (78, 79) étant pivotante entre une position active pour l'insufflation contre la surface respective et une position d'attente contenue dans un couvercle (95, 104).

2. Dispositif de nettoyage selon la revendication 1, dans lequel trois rouleaux d'entraînement (29) sont prévus pour entourer le plateau de montage de plaquettes.

3. Dispositif de nettoyage selon la revendication 1, dans lequel chaque brosse de lavage de surface supérieure (31), la brosse de lavage de surface inférieure (32) et la brosse de lavage de surface latérale (33) peuvent être mises en contact et être mises hors contact par rapport au plateau de montage de plaquettes (6).
